# FASCICULE DE BREVET EUROPEEN

(11) **EP 0 977 252 B1**
(45) Date de publication et mention de la délivrance du brevet: **21.11.2007**
(21) Numéro de dépôt: 99401896.8
(22) Date de dépôt: 26.07.1999
(51) Int. Cl.: H01L 21/58, H01L 21/68, H01L 21/603

(54) **Transfert sélectif d'éléments d'un support vers un autre support**
Selektive Verlegung von Elementen von einem Träger zu einem anderen Träger
Selective transfer of elements from one support to another support

(30) Priorité: 30.07.1998 FR 9809783
(43) Date de publication de la demande: 02.02.2000
(73) Titulaire: COMMISSARIAT A L'ENERGIE ATOMIQUE, 75015 Paris (FR)
(72) Inventeur: Aspar, Bernard, 38140 Rives (FR); Moriceau, Hubert, 38120 Saint-Egreve (FR); Rayssac, Olivier, 38000 Grenoble (FR)
(74) Mandataire: Audier, Philippe André

(56) Documents cités:
- EP-A- 0 029 334
- EP-A- 0 533 551
- WO-A-94/17550
- WO-A-94/17551
- DE-C- 4 410 179
- US-A- 4 941 255
- MASZARA W P ET AL: "BONDING OF SILICON WAFERS FOR SILICON-ON-INSULATOR" 15 novembre 1988 (1988-11-15) , JOURNAL OF APPLIED PHYSICS, VOL. 64, NR. 10, PART 1, PAGE(S) 4943 - 4950 XP000050002

## Description

La présente invention concerne le transfert sélectif d'éléments depuis un support de transfert vers un support de réception.

Elle concerne en particulier le transfert de puces semiconductrices, partiellement ou complètement achevées, depuis leur substrat initial, sur lequel elles ont été élaborées, vers un nouveau substrat (ou support de réception) qui peut lui-même avoir été traité par les techniques de la microélectronique.

L'invention permet le transfert de puces, par exemple le transfert de puces de 1 cm² de surface de leur substrat initial sur du verre ou sur un substrat transparent. Elle permet aussi de transférer des composants optoélectroniques tels que des VCSEL (lasers à cavités verticales) ou de petits morceaux de semiconducteur III-V de leur substrat initial sur des plaquettes de silicium préparées selon les techniques de la microélectronique afin d'obtenir des éléments semiconducteurs III-V sur silicium. Dans ce cas en général, la taille des puces est plus petite, par exemple de l'ordre de 1 mm² ou moins.

### Etat de la technique antérieure

Il est connu de rendre solidaire deux surfaces de matériau semiconducteur par la technique dite d'adhésion moléculaire. L'adhésion moléculaire comprend deux types de collage : le collage hydrophile et le collage hydrophobe. Dans le cas du collage hydrophile, le collage résulte de l'évolution d'interactions -OH à la surface d'une structure vers la formation par exemple de liaisons Si-O-Si dans le cas d'oxyde de silicium. Les forces associées à ce type d'interaction sont fortes. L'énergie de collage, de l'ordre de 100 mJ/m² à température ambiante, atteint 500 mJ/m² après recuit à 400°C pendant 30 minutes (valeurs obtenues pour un collage SiO₂ natif ou hydrophile - SiO₂ thermique non poli) . L'énergie de collage est généralement déterminée par la méthode de lame divulguée par W.P. MASZARA et al. dans l'article "Bonding of silicon wafers for silicon-on-insulator" paru dans J. Appl. Phys. 64(10), 15 novembre 1988, pages 4943-4950. Pour un collage oxyde de silicium déposé et poli - oxyde de silicium déposé et poli, l'énergie de collage est de l'ordre de 1 J/m² pour un recuit sous les mêmes conditions. Par contre, si une surface traitée hydrophile est collée par adhésion moléculaire sur une surface traitée hydrophobe, un collage de très mauvaise qualité est obtenu et les forces de collage sont très faibles : énergie de collage de l'ordre de 100 mJ/m² après un recuit à 400°C pendant 30 minutes.

Dans le cas du collage hydrophobe, celui-ci se fait par adhésion moléculaire sans groupement OH. Dans le cas du silicium, le collage par adhésion moléculaire de plaques hydrophobes peut également permettre l'obtention de forces d'adhésion importantes. A titre d'exemple, on peut citer les travaux de Y. BACKLUND et al. mentionnés dans l'article "A suggested mechanism for silicon direct bonding from studying hydrophilic and hydrophobic surfaces" paru dans J. Michromech. Microeng. 2 (1992), pages 158-160. Il y est montré qu'après un recuit à 400°C, des forces de l'ordre de 1 J/m² sont obtenues après un collage de plaques de silicium hydrophobes

### Exposé de l'invention

La présente invention a été conçue pour permettre d'obtenir un transfert sélectif d'éléments depuis un premier support vers un support de réception. Pour parvenir à ce résultat, elle peut en particulier mettre en oeuvre la technique d'adhésion moléculaire.

L'invention a donc pour objet un procédé de transfert sélectif d'éléments depuis un support de transfert vers un support de réception, les éléments adhérant par une première face au support de transfert selon une énergie d'adhésion définie, les éléments présentant chacun une seconde face susceptible d'être mise en contact avec le support de réception, le procédé comportant les étapes de :
- définition d'au moins un élément à transférer parmi lesdits éléments, impliquant la séparation dudit élément à transférer des éléments à ne pas transférer,
- traitement de la seconde face dudit élément à transférer pour lui conférer une énergie d'adhésion avec le support de réception supérieure à l'énergie d'adhésion de sa première face avec le support de transfert, des moyens de retenue étant prévus pour retenir les éléments à ne pas transférer sur le support de transfert,
- mise en contact adhérent de la seconde face dudit élément à transférer avec le support de réception,
- séparation du support de transfert du support de réception afin d'obtenir le transfert dudit élément à transférer sur le support de réception et le maintien des autres éléments sur le support de transfert.

Le procédé peut comporter les étapes préliminaires suivantes :
- formation desdits éléments sur une face d'un substrat initial, les éléments reposant sur ladite face du substrat initial par leur seconde face,
- solidarisation de la face du substrat initial comportant lesdits éléments avec le support de transfert de manière que les éléments y adhèrent par leur première face selon ladite énergie d'adhésion définie,
- élimination du substrat initial pour permettre aux éléments de présenter leur seconde face.

Dans certains cas, il peut être intéressant de traiter les plaques en couches minces plusieurs fois avant le transfert des éléments. On peut ainsi réaliser des dispositifs double face et choisir l'une ou l'autre face comme face de contact.

De manière préférentielle, la solidarisation de la face du substrat initial comportant lesdits éléments avec le support de transfert est obtenue par adhésion moléculaire. Dans ce cas, il est avantageux que cette adhésion moléculaire soit réalisée par un ou plusieurs traitements des faces à solidariser du substrat initial et/ou du support de transfert de façon à contrôler l'hydrophilie et/ou l'hydrophobie et/ou une microrugosité satisfaisante pour l'obtention de ladite énergie d'adhésion définie. Avantageusement, un traitement thermique peut être mis en oeuvre, globalement ou localement, pour contribuer à l'obtention de cette énergie d'adhésion. Les éléments peuvent inclure une couche, dite couche d'arrêt, par laquelle ils sont reliés au substrat initial. L'élimination du substrat initial peut être obtenue par une ou plusieurs techniques parmi : la rectification, l'attaque chimique du substrat initial et/ou de la couche d'arrêt, le polissage, la séparation suite à un traitement thermique le long d'un plan de clivage induit par implantation ionique.

Si les éléments forment une couche continue sur le support de transfert, l'étape de définition d'au moins un élément à transférer peut comporter l'isolement de l'élément à transférer. De façon avantageuse, cet isolement peut être réalisé par gravure chimique, découpe par lame, gravure par laser ou tout autre moyen de découpe. De préférence, lorsque cet isolement est réalisé par gravure, celle-ci est menée de façon à former des pieds de gravure à proximité du support de transfert.

La mise en contact adhérent de la seconde face dudit élément à transférer avec le support de réception peut être obtenue par adhérence moléculaire. Un traitement thermique peut être mis en oeuvre, globalement ou localement, pour contribuer à l'obtention de l'énergie d'adhésion définie entre la seconde face dudit élément à transférer et le support de réception. L'adhésion par adhérence moléculaire de la seconde face dudit élément à transférer et du support de réception peut être obtenue par un traitement de ladite seconde face et/ou de tout ou partie du support de réception. Les moyens de retenue peuvent consister à traiter les éléments à ne pas transférer et/ou des zones du support de réception non aptes à recevoir des éléments de façon qu'il n'y ait pas adhésion entre les éléments à ne pas transférer et le support de réception. Ils peuvent consister à modifier la surface des éléments à ne pas transférer et/ou la surface desdites zones du support de réception non aptes à recevoir des éléments de façon à rendre l'énergie d'adhésion entre les éléments à ne pas transférer et le support de réception inférieure à L'énergie d'adhésion entre les éléments à transférer et le support de réception et inférieure à l'énergie d'adhésion entre les premières faces des éléments et le support de transfert. Le traitement conférant lesdits moyens de retenue peut être choisi parmi un ou plusieurs des traitements suivants: hydrophilie, hydrophobie, rugosité, traitement thermique, retrait de surface.

Si, lors de l'étape de mise en contact adhérent la seconde face d'éléments à ne pas transférer vient en contact avec le support de réception, les moyens de retenue peuvent consister à traiter la seconde face de ces éléments à ne pas transférer pour lui conférer une qualité de collage hydrophobe avec le support de réception, la seconde face dudit élément à transférer étant traitée pour lui conférer une qualité de collage hydrophile, le support de réception offrant à la seconde face de chaque élément une qualité de collage hydrophile. Ils peuvent aussi consister à traiter la zone du support de réception en regard de la seconde face d'un élément à ne pas transférer pour lui conférer une qualité de collage hydrophobe, la zone du support de réception en regard de la seconde face dudit élément à transférer étant traitée pour lui conférer une qualité de collage hydrophile, toutes les secondes faces des éléments étant traitées pour leur conférer une qualité de collage hydrophile. Il est bien évident que le cas d'un collage hydrophile-hydrophile avec une préparation hydrophobe des zones à ne pas transférer (au niveau des éléments et/ou du support de réception) n'est qu'un exemple car le procédé peut également être mis en oeuvre dans le cas d'un collage hydrophobe-hydrophobe avec traitement hydrophile au niveau des zones à ne pas transférer (au niveau des éléments et/ou du support de réception). De plus, on peut également modifier fortement les forces d'adhésion et les rendre incompatibles avec un contact adhérent en modifiant de façon locale la rugosité de surface.

Dans le cas d'un collage par adhésion moléculaire, les traitements thermiques modifient fortement les forces d'adhésion. C'est donc un paramètre important à prendre en compte et il peut alors être astucieux si l'on veut contrôler localement les forces d'adhésion de réaliser localement un ou plusieurs traitements thermiques pour obtenir les forces d'adhésion souhaitées. Une variante du procédé consiste donc à réaliser localement le traitement thermique de façon à ne chauffer que les zones où l'on souhaite le transfert entre les éléments et le support de réception. Le chauffage peut être réalisé à l'aide d'un laser ou d'une pointe chauffante. Si toutes les secondes faces des éléments ainsi que le support de réception sont traités pour leur conférer une qualité de collage de même type, lesdits moyens de retenue peuvent consister soit à effectuer un traitement thermique local, soit à prévoir une absence de contact mécanique entre la seconde face des éléments à ne pas transférer et le support de réception. Par exemple, cette absence de contact sera liée à un retrait local sur la seconde face et/ou sur le support de réception.

Avantageusement, la séparation du support de transfert et du support de réception est consécutif à un effort mécanique exercé entre ces supports et consistant en un effort de traction et/ou un effort de cisaillement et/ou un effort de flexion, le tout pouvant être assisté thermiquement.

Le procédé selon l'invention s'applique en particulier au cas où lesdits éléments comprennent des composants électroniques, par exemple des puces semiconductrices et/ou des éléments passifs. Les éléments cités trouvant des applications en microélectronique, en optoélectronique ou même dans le domaine des supraconducteurs.

### Brève description des dessins

L'invention sera mieux comprise et d'autres avantages et particularités apparaîtront à la lecture de la description qui va suivre, donnée à titre d'exemple non limitatif, accompagnée des figures annexées 1 à 8 qui sont des vues en coupe transversale illustratives de la mise en oeuvre de la présente invention pour le transfert de puces semiconductrices élaborées sur un substrat initial.

### Description détaillée de modes de réalisation de l'invention

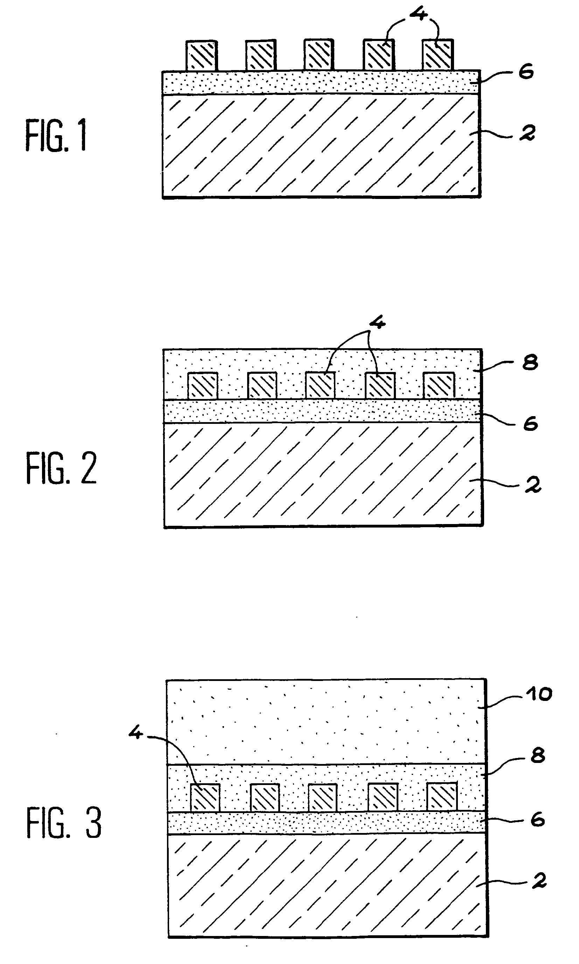

La figure 1 montre un substrat 2, dit substrat initial, par exemple en silicium, sur lequel on a élaboré des puces semiconductrices 4 selon les techniques connues de l'homme de l'art. Une couche d'arrêt 6, par exemple en oxyde de silicium, peut éventuellement être prévue entre les puces semiconductrices 4 et le substrat initial 2. Cette couche d'arrêt procure l'avantage d'une meilleure homogénéité du transfert par la suite car elle constitue une couche d'arrêt par exemple vis-à-vis d'une gravure chimique et/ou d'une gravure par plasma sélectif.

Les puces semiconductrices 4 sont destinées à être transférées de manière sélectives. Pour ce faire, la surface du substrat initial présentant les puces va être préparée pour permettre un collage hydrophile avec une énergie de collage contrôlée. Cette préparation de surface, illustrée par la figure 2, peut comprendre le dépôt d'une couche 8 dans laquelle les puces semiconductrices 4 sont noyées. La couche 8 peut être une couche d'oxyde de silicium ayant subi une opération de planarisation si la topologie de sa surface libre le nécessite.

L'énergie de collage d'une surface peut être contrôlée en jouant sur la rugosité de cette surface. A titre d'exemple, pour un collage par adhésion moléculaire de deux plaques d'oxyde SiO₂ entre elles (oxyde thermique non poli dans chaque cas), une rugosité de l'ordre de 6 angströms en moyenne quadratique obtenue par attaque HF procure une énergie de collage de l'ordre de 250 mJ/m² après un recuit à une température de 400°C pendant 30 minutes.

Comme le montre la figure 3, un support de transfert ou poignée 10 est collé sur la face libre de la couche 8. Si les faces collées ensemble de la couche 8 et du support de transfert 10 présentent chacune une rugosité de l'ordre de 6 angströms rms, l'énergie de collage obtenue est de l'ordre de 250 mJ/m². Pour éviter d'éventuels problèmes d'alignement, la poignée 10 peut être transparente (par exemple en verre ou en silice pure).

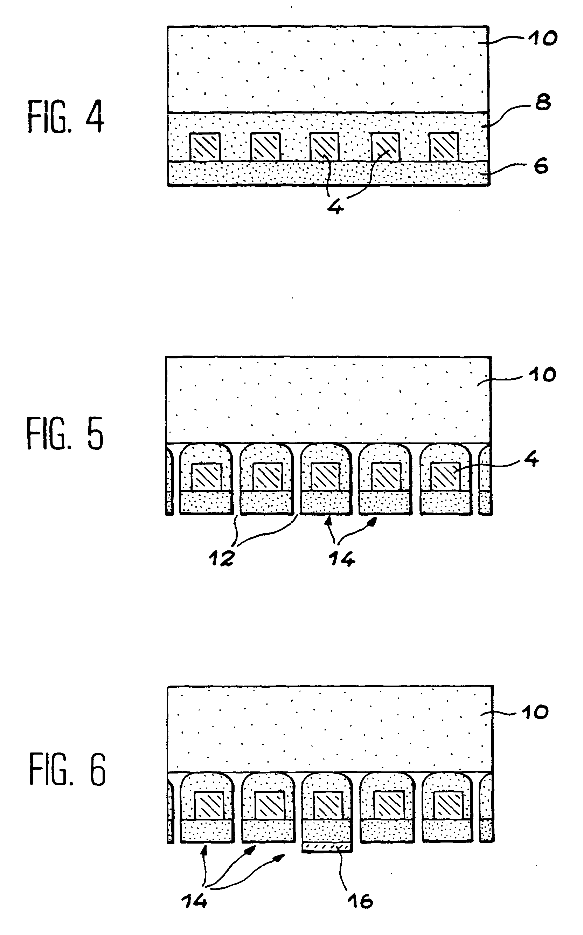

Le substrat initial est ensuite éliminé (voir la figure 4) par une méthode classique ou une combinaison de méthodes classiques. On peut citer la rectification mécanique, le polissage ou la séparation obtenue suite à un traitement thermique le long d'un plan de clivage induit par implantation ionique. Cette dernière méthode est notamment décrite dans le document FR-A-2 681 472. Cette réalisation peut également être obtenue par gravure chimique, réactive, sélective ou par ultra-sons.

Les éléments à transférer sont ensuite délimités. On peut par exemple pour cela réaliser des tranchées de délimitation par gravure chimique ou sèche, par une scie circulaire, une scie à disque, par une découpe aux ultra-sons. C'est ce que montre la figure 5 où des tranchées 12, taillées jusqu'au support de transfert 10, délimitent des éléments 14, chaque élément comprenant une puce semiconductrice 4.

Plusieurs configurations sont possibles pour les tranchées. Il est avantageux de prévoir des pieds de gravure, ainsi que le montre la figure 5, afin d'obtenir des amorces de rupture par la suite. Ces pieds de gravure peuvent être obtenus de façon classique par gravure sèche et/ou par attaque chimique préférentielle au niveau de l'interface de collage avec le support de transfert 10.

La surface libre des éléments 14 est ensuite préparée (par exemple : nettoyage de surface et/ou dépôt d'un film très fin d'oxyde) pour avoir un très bon collage hydrophile. Dans certains cas, il peut être nécessaire de réaliser un polissage du type mécano-chimique pour avoir une microrugosité compatible avec le collage par adhésion moléculaire. Par préparation hydrophile, on entend tout traitement de surface qui permet d'obtenir des groupements OH en surface.

La surface libre des éléments qui ne doivent pas être transférés est traitée pour la rendre hydrophobe. Ce traitement permet donc de délimiter des zones hydrophiles et hydrophobes. Les zones peuvent être rendues hydrophobes par exemple à l'aide d'un traitement HF dans le cas de l'oxyde de silicium, par un traitement plasma ou par un autre traitement chimique localisé. On peut également citer l'utilisation d'un objet qui permet de modifier l'hydrophilie lorsqu'il est mis en contact. A titre d'exemple, on peut citer l'utilisation d'une pointe en téflon^{®} dont la taille est égale à la surface à traiter.

La figure 6 illustre de manière symbolique un tel traitement. L'un des éléments 14 est représenté avec un traitement de surface hydrophile 16 tandis que les autres éléments 14 présentent des surfaces hydrophobes.

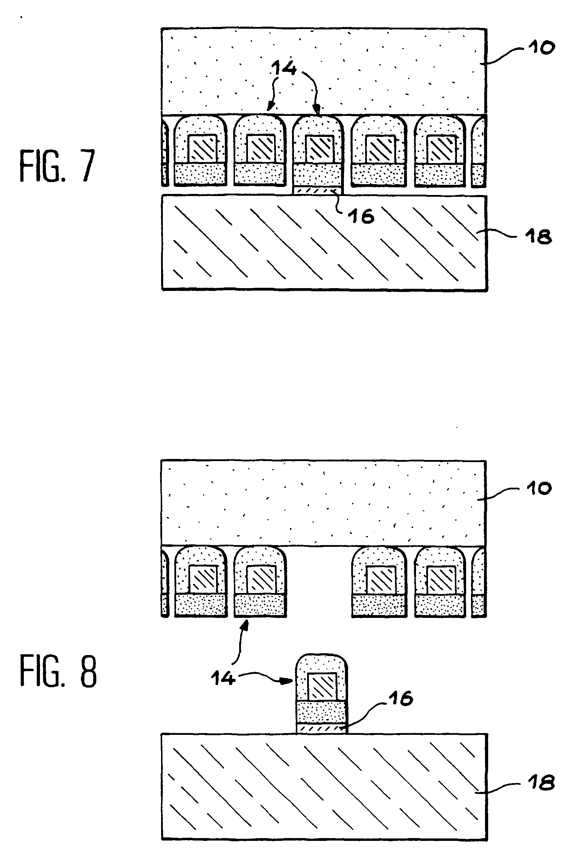

Ainsi préparé, le support de transfert 10 pourvu des éléments 14 peut être collé sur le support de réception 18 qui a été nettoyé de façon telle que la surface qu'il présente aux éléments 14 est hydrophile. Dans la structure représentée à la figure 7, l'énergie de collage entre les éléments 14 et le support de transfert 10 est de l'ordre de 250 mJ/m². L'énergie de collage entre l'élément 14 présentant le traitement de surface hydrophile 16 et le support de réception 18 est supérieure à 500 mJ/m². L'énergie de collage entre les autres éléments 14 présentant un traitement de surface hydrophobe et la surface hydrophile du support de réception 18 est de l'ordre de 100 mJ/m². On rappelle que les forces de collage peuvent être contrôlées à l'aide d'un traitement thermique, par exemple à une température de 400°C pendant 30 minutes.

A partir d'une telle structure, il suffit d'exercer un effort mécanique entre les deux supports 10 et 18 pour obtenir, grâce au contrôle des énergies de collage, le transfert d'un élément traité de manière hydrophile sur la surface hydrophile du support de réception 18. Le reste des éléments, qui a été traitée de manière hydrophobe, reste sur le support de transfert 10. C'est ce que montre la figure 8.

Le procédé selon l'invention autorise un positionnement précis d'un élément (comprenant une puce semiconductrice) sur son nouveau support à l'aide de moyens standard de lithographie ou, de préférence, à l'aide d'une poignée transparente par alignement optique ou avec une poignée microcristalline pour alignement par rayons X. Il permet le transfert d'éléments en plusieurs fois ou le transfert de plusieurs éléments à la fois. Il permet aussi le transfert de tout type de matériau solide. La taille des puces semiconductrices que l'on peut ainsi transférer peut aller de quelques dizaines de micromètres carrés à plusieurs centimètres carrés.

Le transfert des éléments, selon le procédé de l'invention, n'est assuré que dans les zones où le collage est effectif par contact de surfaces hydrophiles entre les éléments et le support de réception. Pour cela, différentes variantes peuvent être envisagées. La surface des éléments à transférer peut être rendue hydrophile de même que la surface correspondante du support de réception tandis que la surface des éléments à ne pas transférer est rendue hydrophobe (cas décrit ci-dessus).

Selon une autre variante, la surface de tous les éléments est rendue hydrophile de même que la surface correspondante du support de réception en regard des éléments à transférer tandis que les zones du support de réception en regard des éléments à ne pas transférer sont rendues hydrophobes.

Selon encore une autre variante, la surface de tous les éléments est rendue hydrophile de même que la surface du support de réception. Les éléments à ne pas transférer sont mis en retrait. Dans ce cas, seuls les éléments à transférer entrent en contact avec le support de réception. La mise en retrait peut être obtenue par gravure chimique et/ou gravure sèche, par exemple, si on est en présence de SiO₂ par gravure chimique avec du HF. Une lithographie peut être réalisée pour délimiter les zones à traiter.

Selon encore une autre variante, la surface de tous les éléments est rendue hydrophile de même que la surface du support de réception dont les zones en regard des éléments à ne pas transférer sont en retrait.

Le procédé selon l'invention s'applique au transfert individuel ou au transfert collectif d'éléments de leur support initial vers leur support de réception. A titre d'exemple, si un substrat comporte 150 puces semiconductrices transférables et que l'on désire ne transférer que 50 puces à la fois sur le support de réception, on peut, en calculant le pas entre les puces, transférer d'abord 50 puces, puis décaler l'un des supports du pas défini, transférer à nouveau 50 puces, effectuer un nouveau décalage du pas défini et transférer à nouveau les 50 dernières puces.

Une autre variante du procédé consiste à utiliser des traitements chimiques ou physiques qui modifient fortement la rugosité de façon locale. Par exemple, si l'on rugosifie les zones à ne pas coller par nettoyage chimique de façon à obtenir des rugosités de l'ordre de 15 angströms en moyenne quadratique, même après un nettoyage hydrophile les forces de collage seront tellement faibles que le transfert n'aura pas lieu dans les zones à forte rugosité. Ce traitement sélectif peut être réalisé sur les éléments à transférer ou sur le support de réception.

## Revendications

1. Procédé de transfert sélectif d'éléments (14) depuis un support de transfert (10) vers un support de réception (18), les éléments (14) adhérant par une première face au support de transfert (10) selon une énergie d'adhésion définie, les éléments (14) présentant chacun une seconde face susceptible d'être mise en contact avec le support de réception (18), le procédé comportant les étapes de :
- définition d'au moins un élément à transférer parmi lesdits éléments (14), impliquant la séparation dudit élément à transférer des éléments à ne pas transférer,
- traitement de la seconde face dudit élément (14) à transférer pour lui conférer une énergie d'adhésion avec le support de réception (18) supérieure à l'énergie d'adhésion de sa première face avec le support de transfert (10), des moyens de retenue étant prévus pour retenir les éléments à ne pas transférer sur le support de transfert (10),
- mise en contact adhérent de la seconde face dudit élément (14) à transférer avec le support de réception (18),
- séparation du support de transfert (10) du support de réception (18) afin d'obtenir le transfert dudit élément à transférer sur le support de réception et le maintien des autres éléments sur le support de transfert.

2. Procédé selon la revendication 1, **caractérisé en ce qu'**il comporte les étapes préliminaires suivantes :
- formation desdits éléments sur une face d'un substrat initial (2), les éléments reposant sur ladite face du substrat initial (2) par leur seconde face,
- solidarisation de la face du substrat initial (2) comportant lesdits éléments avec le support de transfert (10) de manière que les éléments y adhèrent par leur première face selon ladite énergie d'adhésion définie,
- élimination du substrat initial (2) pour permettre aux éléments de présenter leur seconde face.

3. Procédé selon la revendication 2, **caractérisé en ce que** la solidarisation de la face du substrat initial (2) comportant lesdits éléments avec le support de transfert (10) est obtenue par adhésion moléculaire.

4. Procédé selon la revendication 3, **caractérisé en ce que** cette adhésion moléculaire est réalisée par un ou plusieurs traitements des faces à solidariser du substrat initial (2) et/ou du support de transfert (10) de façon à contrôler l'hydrophilie et/ou l'hydrophobie et/ou une microrugosité satisfaisante pour l'obtention de ladite énergie d'adhésion définie.

5. Procédé selon la revendication 3, **caractérisé en ce qu'**un traitement thermique est mis en oeuvre, globalement ou localement, pour contribuer à l'obtention de l'énergie d'adhésion définie entre la face du substrat (2) comportant lesdits éléments et le support de transfert (10).

6. Procédé selon l'une quelconque des revendications 2 à 5, **caractérisé en ce que** les éléments incluent une couche (6), dite couche d'arrêt, par laquelle ils sont reliés au substrat initial (2).

7. Procédé selon l'une quelconque des revendications 2 à 6, **caractérisé en ce que** l'élimination du substrat initial (2) est obtenue par une ou plusieurs techniques parmi : la rectification, l'attaque chimique du substrat initial et/ou de la couche d'arrêt, le polissage, la séparation suite à un traitement thermique le long d'un plan de clivage induit par implantation ionique.

8. Procédé selon l'une quelconque des revendications 1 à 7, **caractérisé en ce que** les éléments (14) formant une couche continue sur le support de transfert, l'étape de définition d'au moins un élément à transférer comporte l'isolement de l'élément à transférer.

9. Procédé selon la revendication 8, **caractérisé en ce que** cet isolement est réalisé par l'une des techniques suivantes : gravure chimique, découpe par lame, gravure par laser.

10. Procédé selon la revendication 9, **caractérisé en ce que**, lorsque l'isolement est réalisé par gravure, celle-ci est menée de façon à former des pieds de gravure à proximité du support de transfert (10).

11. Procédé selon l'une quelconque des revendications 1 à 10, **caractérisé en ce que** la mise en contact adhérent de la seconde face dudit élément (14) à transférer avec le support de réception (18) est obtenue par adhérence moléculaire.

12. Procédé selon la revendication 11, **caractérisé en ce qu'**un traitement thermique est mis en oeuvre, globalement ou localement, pour contribuer à l'obtention de l'énergie d'adhésion définie entre la seconde face dudit élément à transférer et le support de réception.

13. Procédé selon la revendication 11, **caractérisé en ce que** l'adhésion par adhérence moléculaire de la seconde face dudit élément (14) à transférer et du support de réception est obtenue par un traitement de ladite seconde face et/ou de tout ou partie du support de réception (18).

14. Procédé selon l'une quelconque des revendications précédentes, **caractérisé en ce que** lesdits moyens de retenue consistent à traiter les éléments à ne pas transférer et/ou des zones du support de réception non aptes à recevoir des éléments de façon qu'il n'y ait pas adhésion entre les éléments à ne pas transférer et le support de réception.

15. Procédé selon la revendication 14, **caractérisé en ce que** lesdits moyens de retenue consistent à modifier la surface des éléments à ne pas transférer et/ou la surface desdites zones du support de réception non aptes à recevoir des éléments de façon à rendre l'énergie d'adhésion entre les éléments à ne pas transférer et le support de réception inférieure à l'énergie d'adhésion entre les éléments à transférer et le support de réception et inférieure à l'énergie d'adhésion entre les premières faces des éléments et le support de transfert.

16. Procédé selon la revendication 14, **caractérisé en ce que** le traitement conférant lesdits moyens de retenue est choisi parmi un ou plusieurs des traitements suivants : hydrophilie, hydrophobie, rugosité, traitement thermique, retrait de surface.

17. Procédé selon la revendication 14, **caractérisé en ce que**, lors de l'étape de mise en contact adhérent la seconde face d'éléments (14) à ne pas transférer venant en contact avec le support de réception (18), lesdits moyens de retenue consistent à traiter la seconde face de ces éléments à ne pas transférer pour lui conférer une qualité de collage hydrophobe avec le support de réception (18), la seconde face dudit élément à transférer étant traitée pour lui conférer une qualité de collage hydrophile, le support de réception (18) offrant à la seconde face de chaque élément une qualité de collage hydrophile.

18. Procédé selon la revendication 14, **caractérisé en ce que**, lors de l'étape de mise en contact adhérent la seconde face d'éléments à ne pas transférer venant en contact avec le support de réception, lesdits moyens de retenue consistent à traiter la zone du support de réception en regard de la seconde face d'un élément à ne pas transférer pour lui conférer une qualité de collage hydrophobe, la zone du support de réception en regard de la seconde face dudit élément à transférer étant traitée pour lui conférer une qualité de collage hydrophile, toutes les secondes faces des éléments étant traitées pour leur conférer une qualité de collage hydrophile.

19. Procédé selon l'une quelconque des revendications 4, 16, 17 et 18, **caractérisé en ce que** l'hydrophilie de surface est obtenue par au moins l'une des méthodes suivantes : nettoyage, rugosité et dépôt.

20. Procédé selon l'une quelconque des revendications 4, 16, 17 et 18, **caractérisé en ce que** l'hydrophobie de surface est obtenue par au moins l'une des méthodes suivantes : nettoyage et pollution par un contact avec du téflon^{®}

21. Procédé selon l'une quelconque des revendications 1 à 20, **caractérisé en ce que** la séparation du support de transfert et du support de réception est consécutif à un effort mécanique exercé entre ces supports et consistant en un effort de traction et/ou un effort de cisaillement et/ou un effort de flexion.

22. Application du procédé selon l'une quelconque des revendications 1 à 21 au cas où lesdits éléments (14) comprennent des composants électroniques.

23. Application selon la revendication 22, **caractérisée en ce que** les composants électroniques sont des puces semiconductrices (14).

## Claims

1. Process for the selective transfer of elements (14) from a transfer support to a reception support (18), the elements bonding through a first face to the transfer support (10) with a defined bonding energy, each of the elements (14) having a second face that may be put into contact with the reception support (18), the process comprising the following steps:
- definition of at least one element to be transferred among the said elements (14), involving separation of the said element to be transferred from elements that are not to be transferred,
- treatment of the second face of the said element (14) to be transferred to give it a bonding energy with the reception support (18) exceeding the bonding energy between its first face and the transfer support (10), retaining means being provided to retain elements not to be transferred onto the transfer support (10),
- the second face of the said element (14) to be transferred is put into bonding contact with the reception support (18),
- separation of the transfer support (10) from the reception support (18) in order to transfer said element to be transferred onto the reception support and to retain other elements on the transfer support.

2. Process according to claim 1, **characterized in that** it comprises the following preliminary steps:
- formation of the said elements on a face of an initial substrate (2), the elements being supported on the said face of the initial substrate (2) through their second face,
- the face of the initial substrate (2) comprising the said elements is fixed to the transfer support (10) such that the elements bond to it through their first face according to the said defined bonding energy,
- elimination of the initial substrate (2) so that the second face of the elements is exposed.

3. Process according to claim 2, **characterized in that** the face of the initial substrate (2) comprising the said elements is fixed to the transfer support by molecular bonding.

4. Process according to claim 3, **characterized in that** this molecular bonding is achieved by one or several treatments of faces to be fixed to the initial substrate (2) and/or the transfer support (10) so as to control the hydrophilia and/or hydrophobia and/or micro-roughness capable of obtaining the said defined bonding energy.

5. Process according to claim 3, **characterized in that** a heat treatment is applied globally or locally to contribute to obtaining the bonding energy defined between the face of the substrate (2) comprising the said elements and the transfer support (10).

6. Process according to any one of the claims 2 to 5, **characterized in that** the elements include a layer (6), called the stop layer, by which they are bonded to the initial substrate (2).

7. Process according to any one of the claims 2 to 6, **characterized in that** the initial substrate (2) is eliminated by one or several techniques among grinding, chemical etching of the initial substrate and/or the stop layer, polishing, separation subsequent to heat treatment along a plane of cleavage induced by ionic implantation.

8. Process according to any one of the claims 1 to 7, **characterized in that** elements (14) forming a continuous layer over the transfer support, the step defining at least one element to be transferred comprises isolation of the element to be transferred.

9. Process according to claim 8, **characterized in that** this isolation is made by chemical etching, cutting by blade or laser etching.

10. Process according to claim 9, **characterized in that** when the isolation is done by etching, etching is done so as to form etching stands close to the transfer support.

11. Process according to any one of the claims 1 to 10, **characterized in that** the second face of the said element (14) to be transferred is put into bonding contact with the reception support (18) by molecular bonding.

12. Process according to claim 11, **characterized in that** a heat treatment is applied globally or locally to contribute to obtaining the bonding energy defined between the second face of the said element to be transferred and the reception support.

13. Process according to claim 11, **characterized in that** bonding of the second face of the said element (14) to be transferred and the reception support is achieved by treatment of the said second face and/or all or part of the reception support (18).

14. Process according to any one of the preceding claims, **characterized in that** the said retaining means consists of treating elements not to be transferred and/or areas on the reception support not suitable for receiving elements such that there is no bond between elements not to be transferred and the reception support.

15. Process according to claim 14, **characterized in that** the said retaining means consist of modifying the surface of elements not to be transferred and/or the surface of the said reception support areas not suitable for receiving elements in order to make the bonding energy between elements not to be transferred and the reception support less than the bonding energy between elements to be transferred and the reception support, and less than the bonding energy between the first faces of the elements and the transfer support.

16. Process according to claim 14, **characterized in that** the treatment resulting in the said retaining means is chosen among hydrophilia, hydrophobia, roughness, heat treatment, surface shrinkage, or more than one of these treatments.

17. Process according to claim 14, **characterized in that** during the step in which the second face of elements (14) not to be transferred is put into bonding contact with the reception support (18), the said retaining means consist of treating the second face of these elements not to be transferred to give it a hydrophobic bonding capacity with the reception support (18), the second face of the said element to be transferred being treated to give it a hydrophilic bonding capacity, the reception support (18) offering a hydrophilic bonding capacity to the face of each element.

18. Process according to claim 14, **characterized in that**, during the step in which the second face of elements not to be transferred is put into bonding contact with the reception support, the said retaining means consist of treating the area of the reception support facing the second face of an element not to be transferred to give it a hydrophobic bonding capacity, the area of the reception support facing the second face of the said element to be transferred being treated to give it a hydrophilic bonding capacity, all second faces of the elements being treated to provide them with a hydrophilic bonding capacity.

19. Process according to one of claims 4, 16, 17 and 18, **characterized in that** the surface hydrophilia is obtained by cleaning, roughness and deposition, or a combination of these methods.

20. Process according to one of claims 4, 16, 17 and 18, **characterized in that** the surface hydrophobia is obtained by cleaning or pollution by contact with Teflon®, or a combination of these methods.

21. Process according to any one of the claims 1 to 20, **characterized in that** the transfer support is separated from the reception support as a result of a mechanical force applied between these supports consisting of a tension force and/or a shear force and/or a bending force.

22. Application to the process according to any one of the claims 1 to 21 to the case where said elements (14) comprise electronic components.

23. Application according to claim 22, **characterized in that** the electronic components are semiconductor chips (14).

## Patentansprüche

1. Verfahren für den selektiven Transfer von Elementen (14) von einem Transferträger (10) zu einem Empfangsträger (18), wobei die Elemente (14) mit einer ersten Seite und einer definierten Adhäsionsenergie an dem Transferträger (10) haften, jedes der Elemente (14) eine zweite Seite zur Herstellung des Kontakts mit dem Empfangsträger (18) aufweist, das Verfahren dabei die folgenden Schritte umfasst:
- Definition wenigstens eines zu transferierenden Elements unter den genannten Elementen (14), was die Trennung des genannten zu transferierenden Elements von den nicht zu transferierenden Elementen impliziert,
- Behandlung der zweiten Seite des genannten zu transferierenden Elements (14), um ihr eine Adhäsionsenergie in Verbindung mit dem Empfangsträger (18) zu verleihen, die größer ist als die Adhäsionsenergie seiner ersten Seite in Verbindung mit dem Transferträger (10), wobei Rückhaltemittel vorgesehen sind, um die nicht zu transferierenden Elemente am Transferträger (10) festzuhalten,
- Herstellung des Haftkontakts zwischen der zweiten Seite des zu transferierenden Elements (14) und dem Empfangsträger (18),
- Trennung bzw. Entfernung des Transferträgers (10) vom Empfangsträger (18), um das Transferieren des genannten zu transferierenden Elements zum Empfangsträger und das Festhalten der anderen Elemente am Transferträger zu realisieren.

2. Verfahren nach Anspruch 1, **dadurch gekennzeichnet, dass** es die folgenden vorausgehenden Schritte umfasst:
- Bildung der genannten Elemente auf einer Seite eines Initialsubstrats (2), wobei die Elemente mit ihrer zweiten Seite auf der genannten Seite des Initialsubstrats (2) ruhen,
- Verbindung der die genannten Elemente umfassenden Seite des Initialsubstrats mit dem Transferträger (10), so dass die Elemente mit ihrer ersten Seite entsprechend der genannten definierten Adhäsionsenergie daran haften,
- Eliminierung des Initialsubstrats (2), so dass die Elemente ihre zweite Seite präsentieren.

3. Verfahren nach Anspruch 2, **dadurch gekennzeichnet, dass** die Verbindung der die genannten Elemente umfassenden Seite des Initialsubstrats mit dem Transferträger (10) auf Molekularadhäsion beruht.

4. Verfahren nach Anspruch 3, **dadurch gekennzeichnet, dass** diese Molekularadhäsion durch eine oder mehrere Behandlungen der zu verbindenden Seiten des Initialsubstrats (2) und/oder des Transferträgers (10) realisiert wird, um die Hydrophilie und/oder die Hydrophobie und/oder eine zufriedenstellende Mikrorauhigkeit zur Erzeugung der genannten definierten Adhäsionsenergie zu kontrollieren.

5. Verfahren nach Anspruch 3, **dadurch gekennzeichnet, dass** eine Wärmebehandlung durchgeführt wird, global oder lokal, um zu der Erzeugung der definierten Adhäsionsenergie zwischen der die genannten Elemente umfassenden Seite des Substrats (2) und dem Transferträger (10) beizutragen.

6. Verfahren nach einem der Ansprüche 2 bis 5, **dadurch gekennzeichnet, dass** die Elemente eine Sperrschicht genannte Schicht (6) umfassen, durch die sie mit dem Initialsubstrat (2) verbunden sind.

7. Verfahren nach einem der Ansprüche 2 bis 6, **dadurch gekennzeichnet, dass** man zur Eliminierung des Initialsubstrats (2) eine oder mehrere Techniken unter folgenden auswählt: Schleifen, chemisches Ätzen des Initialsubstrats und/oder der Sperrschicht, Polieren, Abtrennen infolge einer thermischen Behandlung längs einer durch Ionenimplantation erzeugten Spaltungsebene.

8. Verfahren nach einem der Ansprüche 1 bis 7, **dadurch gekennzeichnet, dass** - da die Elemente (14) auf dem Transferträger eine kontinuierliche Schicht bilden, der Schritt zur Definition wenigstens eines zu transferierenden Elements die Isolierung des zu transferierenden Elements umfasst.

9. Verfahren nach Anspruch 8, **dadurch gekennzeichnet, dass** diese Isolierung durch eine der folgenden Techniken erfolgt: chemisches Ätzen, Messerschneiden, L.aserstrahlschneidon.

10. Verfahren nach Anspruch 9, **dadurch gekennzeichnet, dass** - wenn die Isolierung durch Ätzen erfolgt, dieses so durchgeführt wird, dass sich nahe bei dem Transferträger (10) Ätzfüße bilden.

11. Verfahren nach einem der Ansprüche 1 bis 10, **dadurch gekennzeichnet, dass** die Herstellung des Haftkontakts der zweiten Seite des genannten zu transferierenden Elements (14) mit dem Empfangsträger (18) durch Molekularadhäsion erlangt wird.

12. Verfahren nach Anspruch 11, **dadurch gekennzeichnet, dass** eine thermische Behandlung durchgeführt wird, global oder lokal, um zu der Erzeugung der definierten Adhäsionsenergie zwischen der zweiten Seite des genannten zu transferierenden Elements und dem Empfangsträger beizutragen.

13. Verfahren nach Anspruch 11, **dadurch gekennzeichnet, dass** die Adhäsion mittels Molekularhaftung der zweiten Seite des genannten zu transferierenden Elements (14) und des Empfangsträgers durch eine Behandlung der genannten zweiten Seite und/oder der Gesamtheit oder eines Teils des Empfangsträgers (18) erlangt wird.

14. Verfahren nach einem der vorangehenden Ansprüche, **dadurch gekennzeichnet, dass** die genannten Rückhaltemittel aus einer Behandlung der nicht zu transferierenden Elemente und/oder von nicht zum Empfang von Elementen geeigneten bzw. bestimmten Zonen des Empfangsträgers bestehen, so dass es keine Adhäsion zwischen den nicht zu transferierenden Elementen und dem Empfangsträger gibt.

15. Verfahren nach Anspruch 14, **dadurch gekennzeichnet, dass** die genannten Rückhaltemittel aus einer Modifizierung der Oberfläche der nicht zu transferierenden Elemente und/oder der Oberfläche der nicht zum Empfang von Elementen geeigneten bzw. bestimmten Zonen des Empfangsträgers bestehen, um die Adhäsionsenergie zwischen den nicht zu transferierenden Elementen und dem Empfangsträger niedriger als die Adhäsionsenergie zwischen den zu transferierenden Elementen und dem Empfangsträger und niedriger als die Adhäsionsenergie zwischen den ersten Seiten der Elemente und dem Transferträger zu halten.

16. Verfahren nach Anspruch 14, **dadurch gekennzeichnet, dass** man für die die genannten Rückhaltemittel realisierende Behandlung eine oder mehrere der folgenden Behandlungen wählt: Hydrophilie, Hydrophobie, Rauhigkeit, Wärmebehandlung, Oberfiächenschrumpfung.

17. Verfahren nach Anspruch 14, **dadurch gekennzeichnet, dass** in dem Haftkontaktherstellungsschrift, in dem die zweite Seite von nicht zu transferierenden Elementen (14) in Kontakt mit dem Empfangsträger (18) kommt, die genannten Rückhaltemittel darin bestehen, die zweite Seite dieser nicht zu transferierenden Elemente zu behandeln, um ihr eine hydrophobe Klebequalität bezüglich des Empfangsträgers (18) zu verleihen, wobei die zweite Seite des genannten zu transferierenden Elements behandelt wird, um ihr eine hydrophile Klebequalität zu verleihen, und der Empfangsträger (18) der zweiten Seite jedes Elements eine hydrophile Klebequalität bietet.

18. Verfahren nach Anspruch 14, **dadurch gekennzeichnet, dass** in dem Haftkontaktherstellungsschritt, in dem die zweite Seite von nicht zu transferierenden Elementen in Kontakt mit dem Empfangsträger kommt, die genannten Rückhaltemittel darin bestehen, die einer zweiten Seite eines nicht zu transferierenden Elements gegenüberstehende Zone des Empfangsträgers zu behandeln, um ihr eine hydrophobe Klebequalität zu verleihen, wobei die der zweiten Seite des zu transferierenden Elements gegenüberstehende Zone des Empfangsträgers behandelt wird, um ihr eine hydrophile Klebequalität zu verleihen, und alle zweiten Seiten der Elemente behandelt werden, um ihnen eine hydrophile Klebequalität zu verleihen.

19. Verfahren nach einem der Ansprüche 4, 16, 17 und 18, **dadurch gekennzeichnet, dass** man die Oberflächenhydrophilie durch wenigstens eine der folgenden Methoden erlangt: Reinigung, Rauhigkeit und Abscheidung.

20. Verfahren nach einem der Ansprüche 4, 16, 17 und 18, **dadurch gekennzeichnet, dass** man die Oberflächenhydrophobie durch wenigstens eine der folgenden Methoden erlangt: Reinigung und Verunreinigung durch einen Kontakt mit Teflon^{®}.

21. Verfahren nach einem der Ansprüche 1 bis 20, **dadurch gekennzeichnet, dass** die Trennung des Transferträgers und des Empfangsträgers durch eine mechanische Kraft erfolgt, ausgeübt zwischen diesen Trägern und gebildet durch eine Zugkraft und/oder eine Scherkraft und/oder eine Biegekraft.

22. Anwendung des Verfahrens nach einem der Ansprüche 1 bis 21 in dem Fall, wo die genannten Elemente (14) elektronische Bauteile umfassen.

23. Anwendung nach Anspruch 22, **dadurch gekennzeichnet, dass** die elektronischen Bauteile Halbleiterchips (14) sind.
